(19) Europäisches Patentamt / European Patent Office / Office européen des brevets

(11) **EP 2 721 731 B1**

(12) **EUROPEAN PATENT SPECIFICATION**

(45) Date of publication and mention
of the grant of the patent:
**04.11.2015 Bulletin 2015/45**

(51) Int Cl.:
***H03D 7/14*** (2006.01)

(21) Application number: **11727429.0**

(22) Date of filing: **20.06.2011**

(86) International application number:
**PCT/EP2011/060222**

(87) International publication number:
**WO 2012/175107 (27.12.2012 Gazette 2012/52)**

(54) **AN IMPROVED MIXER CIRCUIT**

VERBESSERTE MISCHERSCHALTUNG

MODÈLE AMÉLIORÉ DE CIRCUIT MÉLANGEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.04.2014 Bulletin 2014/17**

(73) Proprietor: **Telefonaktiebolaget L M Ericsson (publ)
164 83 Stockholm (SE)**

(72) Inventor: **BAO, Mingquan
426 54 Västra Frölunda (SE)**

(74) Representative: **Ericsson
Patent Development
Torshamnsgatan 21-23
164 80 Stockholm (SE)**

(56) References cited:
**EP-A1- 2 263 308      US-A1- 2006 128 340**

- **MONTEMAYOR R: "A 410-mW 1.22-GHz Downconverter in a Dual-Conversion Tuner IC for OpenCable Applications", IEEE JOURNAL OF SOLID-STATE CIRCUITS, IEEE SERVICE CENTER, PISCATAWAY, NJ, USA, vol. 39, no. 4, 1 April 2004 (2004-04-01), pages 714-718, XP011109690, ISSN: 0018-9200, DOI: 10.1109/JSSC.2004.825117**
- **WEI ZHUO ET AL: "Using capacitive cross-coupling technique in RF low noise amplifiers and down-conversion mixer design", SOLID-STATE CIRCUITS CONFERENCE, 2000. ESSCIRC '00. PROCEEDINGS OF THE 26RD EUROPEAN STOCKHOLM, SWEDEN 19-21 SEPT. 2000, PISCATAWAY, NJ, USA,IEEE, 19 September 2000 (2000-09-19), pages 77-80, XP010824269, ISBN: 978-2-86332-249-9**

**Description**

TECHNICAL FIELD

The present invention discloses an improved mixer circuit.

BACKGROUND

Mixers are an important component in such electronics systems as, for example, transmitters and receivers. A mixer, as the name implies, mixes two input signals and outputs a signal at a frequency which is a either a sum or a difference of the frequencies of the two input signals. A common use for a mixer is in a receiver, in which a mixer is used in order to convert received radio frequency, RF, signals into intermediate Frequency, IF, signals by means of a Local Oscillator, LO, signal, so called "down conversion", in addition to which a mixer can also be used in a transmitter in order for "up conversion" of a IF signal to an RF frequency signal by means of an LO signal.

A commonly used mixer is so-called Gilbert mixer, which consists of three emitter coupled pairs, in the case of bipolar junction transistors. If FET transistors are used, the transistors are instead "source coupled". Two of the transistor pairs make up what is known as the switching stage of the Gilbert mixer, while the third transistor pair is connected to the switching stage and make up what is known as the "trans-conductance" stage of the Gilbert mixer.

The bases, or gates, depending on the kind of transistor that is used, of the transistors in the trans-conductance stage are used as differential input ports for a first input signal, e.g. an RF signals. This means that there are, in the case of an RF-signal, two input RF signals which have the same amplitude, but which are 180-degree anti-phase with respect to each other. The transistors in the trans-conductance stage transfer the RF voltage signals into RF current signals.

The other two emitter coupled transistor pairs form what is known as the "switching stage" of the Gilbert mixer, and are coupled to each other via the bases of one transistor in each pair. The base of each of the other transistor (i.e. not the emitter connected transistors) in each pair is used as differential input ports for a second input signal, e.g. an LO-signal, so that the LO signal controls the transistor pair in the switching stage to operate approximately at their respective "on" and "off" states.

In a Gilbert mixer, RF current which flows into the switching stage is thus modulated by the LO signals, and generates mixing frequency components.

The collectors of the transistors in the switching stage are used to access output differential mixed signals, so called IF signals, in the case of RF/LO input signals.

The conversion gain of a mixer is usually defined as the ratio between the input power and the output power. In a Gilbert mixer, as well as in a mixer circuit in general, a better conversion gain is often desired. A prior art solution to achieving a better conversion gain is to enhance the gain of the trans-conductance stage of the mixer, and/or to increase the power of the LO signal, in the case of a mixer which mixes RF and LO signals into an IF signal. However, the first solution will cause an increase in the mixer's DC power consumption, and the second solution will be a burden on the LO signal generator.

Patent document EP2263308 discloses a mixer that is based on a capacitively cross-coupled switching stage. It is, however, limited to non-differential signals and uses a balun instead of transconductance stage. The article "Using capacitive cross-coupling technique in RF low noise amplifiers and down-conversion mixer design" by W. Zhuo et al. (proceedings of the 26rd European Solide-State circuits conference, ESSCIRC'00, Stockholm, Sweden 19-21 Sept. 2000, Piscataway NJ, USA, IEEE, pages 77-80) applies capacitive coupling to the transconductance stage of a mixer.

SUMMARY

It is an object of the invention to obtain a mixer, in particular but not exclusively, a Gilbert mixer, which exhibits an improved conversion gain as compared to previous mixers.

This object is achieved by means of a mixer circuit with a switching stage which comprises a first and a second transistor, and with a trans-conductance stage which comprises a first and a second transistor. In the mixer circuit, the first and second transistors in the switching stage are capacitively cross-coupled to each other.

As will be shown in the following detailed description, the capacitive cross-coupling of the transistors in the switching stage leads to a mixer circuit with an improved conversion gain as compared to prior art technology.

In embodiments, the transistors are bipolar junction transistors, and the emitters of the transistors in the trance-conductance stage are coupled to each other as well as being coupled to ground via a DC current source, with the bases of the transistors in the trance-conductance stage forming respective differential input ports for a first input signal at a first frequency. The emitter of each of the transistors in the switching stage form respective differential input ports for a second input signal at a second frequency. The transistors in the switching stage are capacitively cross-coupled to each other by means of the base of each transistor in the switching stage being coupled to the emitter of the other transistor in the switching stage via a capacitor, and the collectors of the transistors in the switching stage are also connected to each other and form an output port for a mixer signal from the mixer circuit as well as forming an input port for a DC supply voltage for the mixer circuit via a resistor.

In addition, the mixer circuit described above can also be used for obtaining a Gilbert mixer with improved characteristics. In embodiments, such a Gilbert mixer comprises a first and a second mixer circuit as defined above, i.e. the transistors are bipolar junction transistors, and in the first and second mixer circuits the connection between the collectors of the transistors in the switching stage is opened. In such a Gilbert mixer, the first and second mixer circuits are connected by means of a connection between the emitters of a first transistor in each switching stage of the mixer circuits and by means of the emitters of the transistors in the trans-conductance stages of the mixer circuits, which are connected to each other as well as being connected to ground via a DC current source.

In addition, in such a Gilbert mixer, the bases of the transistors in each trans-conductance stage of the first and second mixers are connected to each other. The emitters of a second transistor in each of the switching stages are connected to each other and form a first differential input port for a second input signal at a second frequency, and the connection between the first and second mixer circuits forms a second differential input port for the second input signal. The connected bases of the transistors in the trans-conductance stages of each of the mixer circuits form differential input ports for a first input signal at a first frequency, and the collectors of the first transistor in each transistor pair in the switching stages are connected to the collectors of the second transistor in the other switching stage, thereby forming respective differential output ports for a differential output signal of the Gilbert mixer, as well as forming an input port for a DC voltage supply via a resistor.

Instead of bipolar junction transistors, Field Effect Transistors, FET transistors, may also be used, with the ports base-collector-emitter then being replaced by the ports gate-drain-source.

BRIEF DESCRIPTION OF THE DRAWINGS

The invention will be described in more detail in the following, with reference to the appended drawings, in which

Fig 1 shows a prior art Gilbert mixer, and
Fig 2 shows an embodiment of a mixer circuit, and
Fig 3 shows the mixer of fig 2 in a Gilbert mixer, and
Fig 4 shows an emitter coupled transistor pair, and
Fig 5 shows a performance chart for the Gilbert mixer of fig 3 and for a prior art Gilbert mixer, and
Fig 6 shows a capacitive cross-coupled transistor pair, and
Fig 7 shows the fundamental of emitter coupled and capacitive cross-coupled transistor pairs, and
Figs 8 and 9 show the mixers of figs 2 and 3 with FET transistors.

DETAILED DESCRIPTION

Embodiments of the present invention will be described more fully hereinafter with reference to the accompanying drawings, in which embodiments of the invention are shown. The invention may, however, be embodied in many different forms and should not be construed as being limited to the embodiments set forth herein. Like numbers in the drawings refer to like elements throughout. The terminology used herein is for the purpose of describing particular embodiments only, and is not intended to limit the invention.

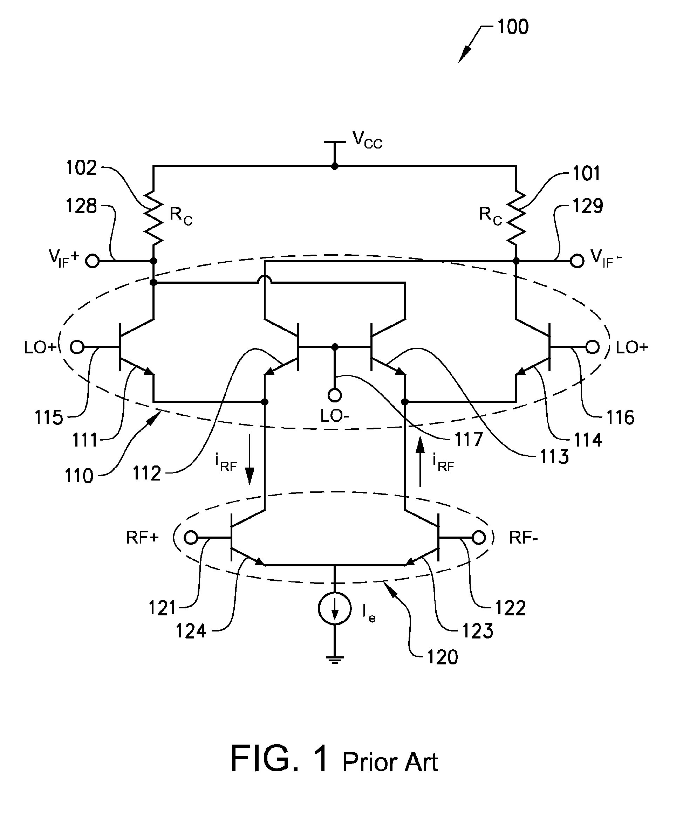

Initially, for reference, a prior art Gilbert mixer will be described with reference to fig 1, which shows such a prior art Gilbert mixer 100. In fig 1, the input signals are shows as differential LO and RF signals, and the output signal is shown as a differential IF (Intermediate Frequency).

The Gilbert mixer 100 comprises a switching stage 110, which comprises two pairs, 111-112 and 113-114, of emitter-coupled bipolar junction transistors. As shown, the transistor pairs are connected by means of a first transistor in each pair, here transistors 112 and 113, having their bases connected to each other, and this connection 117 also serves as one of two differential input ports for a differential second input signal at a second frequency. The bases of the second transistor 111, 114, in each pair are connected to each other and form the other differential input port for the second input signal at the second frequency. In fig 1, input port 117 is shown as the negative differential input port, and the other input port is shown as being the positive input port. Naturally, this can be changed, if a corresponding change is made for the second input signal which is mentioned below..

The Gilbert mixer 100 also comprises a so called trans-conductance stage 120, which comprises a third pair of emitter coupled transistors 123, 124, the bases of which 121, 122, are used as differential input ports for a differential first input signal at a second frequency.

The term "differential input signal" here refers to a signal which occurs or is provided at two different input ports, here referred to as the "positive" and the "negative" input ports, with a 180-degree phase difference in the input signal between the positive and the negative input ports. In fig 1, the bases of transistors 111 and 114 are connected to each other, although this is not explicitly shown in fig 1, for reasons of clarity.

The emitters of the transistors 123, 124, in the trans-conductance stage 120 are coupled to each other and to a DC current source $I_e$. The switching stage 110 and the trans-conductance stage 120 are connected to each other by means of the emitters of the first transistors 112, 113, each being coupled to the collector of one of the transistors 123, 124, in the trans-conductance stage 120.

The output signal $V_{IF}$ from the Gilbert mixer, which is also differential, i.e. it comprises a "positive" and a "negative" component, is accessed at two points, one for each component $V_{IF}+$, $V_{IF}-$, in the differential signal. These two points are indicated as 128 and 129 in fig 1, and are points where the collector of the first transistor 111, 114, in each transistor pair in the switching stage 110 is connected to the collector of the second transistor 113, 112, in the other transistor pair in the switching stage 110.

In addition, a DC supply voltage $V_{CC}$ for the Gilbert mixer 100 is provided to the points 128, 129 via respective resistors $R_C$.

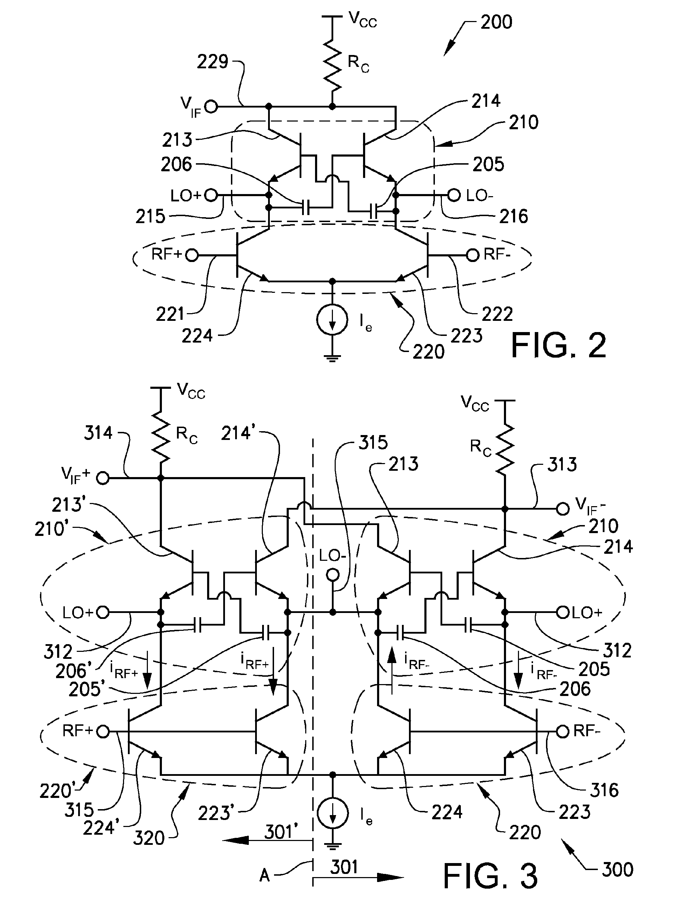

Fig 2 shows an embodiment of a mixer circuit 200 which can either, as will be shown later, be used in pairs to form an improved Gilbert mixer, or can be used as a "stand-alone mixer" with a single-ended (i.e. non-differential) output.

In general, the mixer circuit 200 comprises a switching stage 210 which comprises a first 214 and a second 213 transistor and also has a trans-conductance stage 220 which comprises a first 223 and a second 224 transistor. In the mixer circuit 200, the first 214 and second 213 transistors in the switching stage 210 are capacitively 205, 206 cross-coupled to each other.

Fig 2 shows an embodiment of a mixer 200 with bipolar junction transistors, which will also be used in the description below. However, as will be shown later, Field Effect Transistors, FET transistors can also be used.

Thus, the mixer circuit 200 comprises a trance-conductance stage 220 which comprises a first pair of bipolar junction transistors 223, 224. In the mixer circuit 200, the emitters of the transistors 223, 224 in the trance-conductance 220 stage are coupled to each other and to ground via a DC current source $I_e$.

In addition, the bases of the transistors 223, 224, in the trance-conductance 220 stage form respective differential input ports 221, 222, for a first input signal (shown as an RF signal in fig 2) at a first frequency, i.e. in this example at an RF-frequency.

The mixer circuit 200 also comprises a switching stage 210 with a second pair of bipolar junction transistors 213, 214, in which the emitter of each of the transistors 213, 214 in the switching stage 210 form respective differential input ports 215, 216 for a second input signal (shown as an LO signal in fig 2) at a second frequency.

In the mixer circuit 200, the transistors 213, 214 in the switching stage 210 are capacitively cross-coupled to each other, i.e. the base of each transistor 213, 214 in the switching stage 210 is coupled to the emitter of the other transistor 214, 213 in the switching stage via a capacitor 205, 206.

The collectors of the transistors 213, 214, in the switching stage 210 are also connected to each other, and form an output port for a mixer signal (shown as $V_{IF}$) from the mixer circuit 220 and are also used as an input port for a DC supply voltage $V_{CC}$ for the mixer circuit 200 via a resistor $R_C$.

The capacitive cross-coupling of the transistors 213, 214 in the switching stage 210 gives rise to a number of beneficial effects as compared to prior art mixers, as will be shown by means of performance diagrams later in this text. First, however, an example will be given of how the mixer circuit 200 can be used to obtain an improved Gilbert mixer. This is shown in fig 3, which shows an improved Gilbert mixer 300. The Gilbert mixer 300 comprises two of the mixer circuits 200 from fig 2, as indicated by means of a vertical dashed line "A" in fig 3, which has one of mixer circuits from fig 2, here shown as 300 and 301', on each side of it, one to the left and one to the right of the line "A". Since the Gilbert mixer 300 exhibits two circuits such as the one shown in fig 2, the reference numbers from fig 2 have, as far as possible, been retained for components of the two mixer circuits which make up the Gilbert mixer 300, with a "prime" being attached to the reference numbers of the mixer circuit 301' to the left of the line "A" in fig 3. As an example of this principle, it can be pointed out that corresponding transistors in the two mixer circuits 301, 301' in fig 3 have been given the reference numbers 214 and 214'.

A difference between the mixer circuit 200 in fig 2 and the two mixer circuits (from now on also referred to as the first 301 and the second 301' mixer circuit) which are comprised in the Gilbert mixer 300 is that in the first 301 and second 301' mixer circuits, the connection between the collectors of the transistors 213, 214; 213', 214' in the switching stage is opened, i.e. there is no such connection.

As shown in fig 3, in the Gilbert mixer 300, the first 301 and second 301' mixer circuits are connected by means of a connection between the emitters of a first transistor 213, 214', in the switching stage 210, 210', of the first and second mixer circuits. There is also a connection between the emitters of the transistors 223, 224, 223', 224', in the trans-conductance stage 220, 220', of the first and second mixer circuits, which are connected to each other as well as being connected to ground via a DC current supply $I_e$.

In the Gilbert mixer 300, the bases of the transistors 223 - 224; 223' - 224', in each trans-conductance stage 220, 220' of the two mixer circuits 301, 301', are connected to each other.

The emitter of a second transistor 214, 213', in each of the switching stages are connected to each other (although this is not explicitly shown in fig 3, for reasons of clarity) and form a first differential input port 312 for a second input signal (in fig 3 shown as an LO signal) at a second frequency, and the connection between the first and second mixer forms a second (opposite) differential input port 315 for the second input signal.

The bases of the connected transistors 223, 224 and 223', 224' in the trans-conductance stages 220, 220' form respective differential input ports 316, 315 for a first input signal (shown as an RF signal) at a first frequency, and the collectors of the first 213, 213' transistor in each pair in the switching stages 210, 210' are connected to the collectors of the second 214, 214' transistor in the other switching stage 210', 210, thereby forming respective differential output ports for a differential output signal of the Gilbert mixer, shown as $V_{IF}$, and $V_{IF.}$, as well as forming input ports for a DC voltage supply $V_{CC}$ via respective resistors $R_C$.

The Gilbert mixer 300 can be said to have a mixing stage 310 which is comprised of the two mixing stages 210, 210', of the first 301 and second 301' mixer circuits, and a trans-conductance stage 320 which is comprised of the two trans-conductance stages 220, 220', of the first 301 and second mixer 301' circuits.

Thus, in the Gilbert mixer 300, two capacitively cross-coupled transistor pairs, 213' - 214' and 213 - 214, are used in the switching stage.

In the Gilbert mixer 300, the transistor pairs formed by transistors 223'-224 and transistors 224'-223 have two functions:

  1) To convert the input RF voltage signal into RF current signals shown as $i_{RF+}/i_{RF+}$ in fig 3,

  2) To act as a large impedance load at the emitters of the transistors in the switching stage, i.e. transistors 213', 214', 213 and 214. This is due to the fact that such large impedances are desired to separate the differential LO input signals.

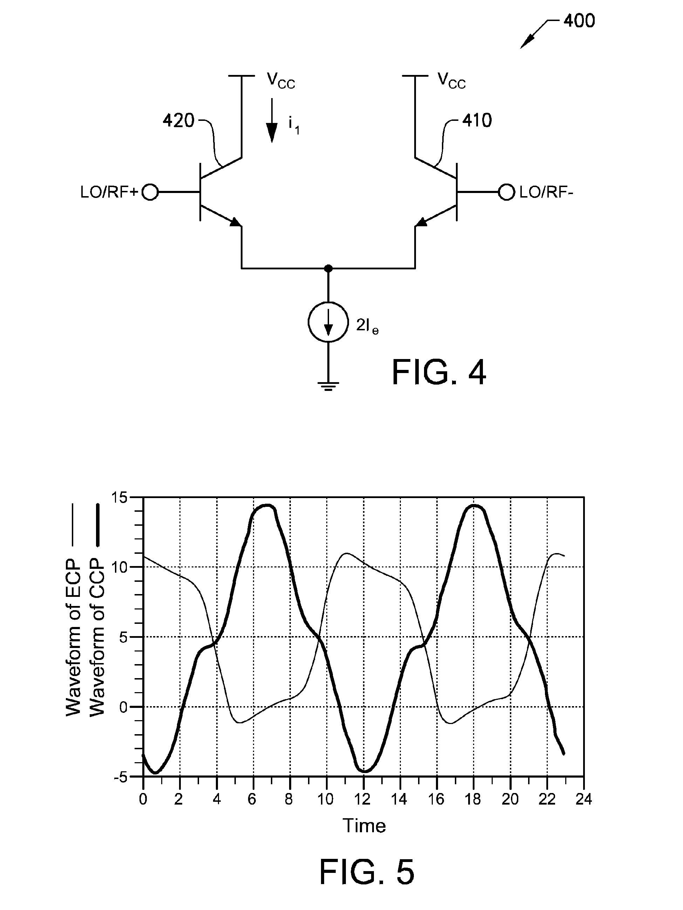

Having now described the circuit topology of the mixer circuit 200 of fig 2 and the Gilbert mixer 300 of fig 3, the mechanism behind the conversion gain of the mixer (both 200 and 300) will now be discussed, i.e. the effects of the capacitively coupled transistor pair in the switching stage will be explained. As a first example, take a traditional emitter coupled transistor pair which is shown as 400 in fig 4, where two transistors 410 and 420 are emitter coupled and have their respective base used as differential input signals for an LO or an RF signal, so that these gates are shown as input ports for LO/RF+ and LO/RF-. In such a case, the collector current, $i_1$, of the transistor 420 is given by:

$$i_1 = \frac{2\alpha_F I_e}{1 + \exp\left(\dfrac{-V_{id}}{V_T}\right)} \qquad (1)$$

where $\alpha_F$ denotes the ratio of collector to emitter current, $2I_e$ is the DC current at the emitters of the transistors, $V_T = \dfrac{kT}{q} \approx 26mV$ at 300°K, and $V_{id} = V_{RF/LO}+ - V_{RF/VLO}-$ is the "difference" of the input RF/LO voltage. The collector current of the other transistor, i.e. transistor 410, forms a differential AC component as referred to $i_1$, so that it can be calculated in the same manner, but has a 180 degree phase difference as compared to the phase of $i_1$.

In a trans-conductance stage, the emitter coupled pair of fig 4 operates at their linear region, i.e. its input differential RF is relative small compared with $V_T$. In this case, the collector current of the two transistors can be approximated as

$$i_{RF} \approx \frac{\alpha_F I_e}{2V_T} V_{id} = g_m V_{RF} \cos(\omega_{RF} t) \qquad (2)$$

where $g_m = \dfrac{\alpha_F I_e}{2V_T}$, $V_{RF}$ and $\omega_{RF}$ are the amplitude and angle frequency of a sinuous RF signal.

The RF currents, shown as $i_1$ in fig 4, which are obtained from the circuit 400 are injected into the LO switching stage, mixed with LO voltage signal, and the collector current at the LO switching stage then becomes:

$$i_c = g_m V_{RF} \cos(\omega_{RF} t) \cdot f(V_{LO})$$
$$= g_m V_{RF} \cos(\omega_{RF} t) \cdot \left[ F_0 + F_1 \cdot V_{LO} \cos(\omega_{LO} t + \varphi_1) + F_2 \cdot V_{LO} \cos(2\omega_{LO} t + \varphi_2) + ... \right] \quad (3)$$

where $f(V_{LO})$ represents the modulation function controlled by the LO voltage signal. The function $f(V_{LO})$ describes the collectors' current response to the LO voltage signal. This function can be expended into series of cosine functions. Below, $F_1$ and $F_2$ are the amplitudes of the fundamental and the second harmonic of, $\omega_{LO}$, the angle frequency of LO signal. The desired down/up mixing components, $(\omega_{LO} - \omega_{RF}) / (M_{LO} + \omega_{RF})$, are given by:

$$I_c = g_m V_{RF} \cos(\omega_{RF} t) \cdot F_1 \cdot V_{LO} \cos(\omega_{LO} t + \varphi_1)$$
$$= \frac{g_m F_1 V_{RF} V_{LO}}{2} \left\{ \cos\left[ (\omega_{LO} + \omega_{RF}) t + \varphi_1 \right] + \cos\left[ (\omega_{LO} - \omega_{RF}) t + \varphi_1 \right] \right\} \quad (4)$$

It can be seen from (4) that the conversion gain for the mixers of figs 2 and 3 is proportional to the following expression:

$$Gain \propto \frac{g_m F_1 V_{LO}}{2} = \frac{\alpha_F I_e F_1 V_{LO}}{4 V_T} \quad (5)$$

Apart from increasing the DC current bias $I_e$ and the LO signal's voltage amplitude $V_{LO}$, there is another approach to get a high conversion gain, namely, increasing $F_1$, i.e. the fundamental current component generated in the switching stage of the mixer.

In a conventional Gilbert mixer, the LO switching stage consists of two emitter coupled pairs, and its modulation function, i.e., the collector current as a function of LO voltage, is given by equation (1) above. When the input voltage swing becomes large ($V_{LO} > 10 V_T$), the collector current is approximately periodic square waves, i.e., the emitter coupled pair works at either "on" or "off" state. Fig 5 shows (bold line) the simulated current for an emitter coupled transistor pair (ECP) and (fine line) for a capacitively coupled transistor pair (CCP), when the amplitude of $V_{LO}$ is 300mV and the DC current $I_e$ is 5mA. The distortion of the square wave is mainly due to the transistors' parasitic capacitance and resistance. The amplitudes of the frequency components, DC, $F_1$, $F_2$, and $F_3$ are listed in table 1 below for both an emitter coupled transistor pair and for a capacitively coupled transistor pair.

Table 1: Amplitudes of the frequency components of emitter coupled pair and capacitive cross-coupling pair

| Frequency | Emitter coupled transistor pair (dBm) | Capacitive cross-coupled transistor pair (dBm) |
|---|---|---|
| 0 | -36.3 | -36.3 |
| $F_1$ | -34.1 | -31.6 |
| $F_2$ | -67.8 | -56.4 |
| $F_3$ | -47.2 | -46.3 |

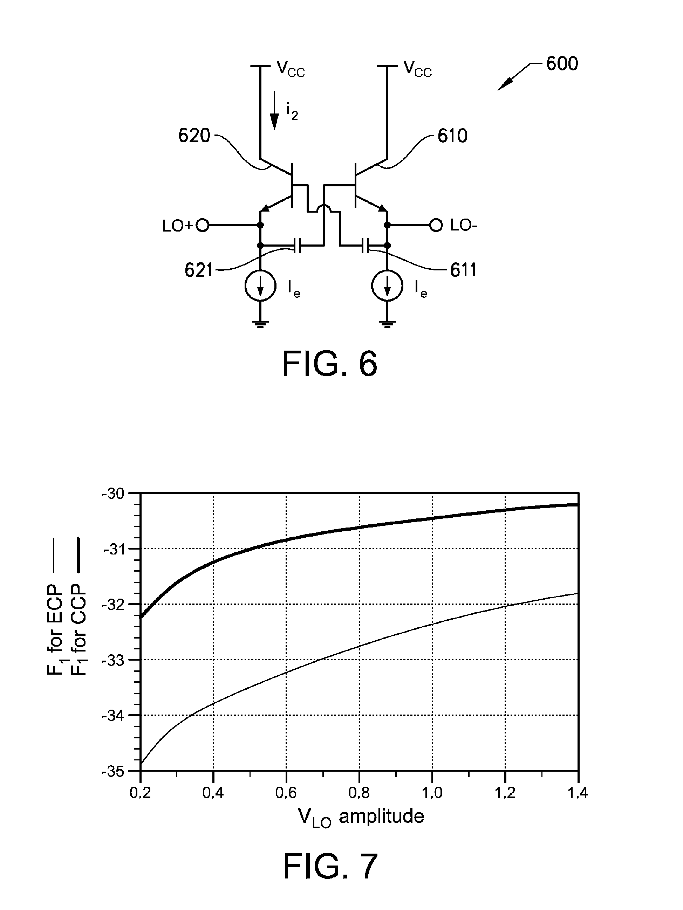

As pointed out previously, in the mixer of the invention, a capacitively cross-coupled transistor pair is used to build the mixer's LO switching stage. Such a capacitively coupled pair of transistors is shown as a circuit 600 in fig 6, with the transistors being denoted as 610 and 620. The transistors 610, 620 are capacitively cross coupled to each other via capacitors 621 and 611, and the emitter currents of the transistors are denoted as $I_e$.

The modulation function which relates the collector current to the LO differential voltage, is given by

$$i_2 = I_e \exp\left( \frac{V_{id}}{V_T} \right) \quad (6)$$

The current $I_2$ corresponds to the simulations of fig 5, which have been commented upon earlier. With renewed reference to fig 5, it can be seen that the waveform of the current for a capacitive cross-coupling pair (fine line, fig 5) is approximately like that of a sine waveform, and its peak-to-peak current swing is larger than that of an emitter coupled transistor pair (bold line, fig 5). Consequently, a larger fundamental amplitude $F_1$ is available in the case of a capacitively coupled transistor pair.

As pointed out, in table 1 above, the obtained amplitudes for different harmonics are listed. It can be seen that, for a capacitive cross-coupled pair, the amplitude of the fundamental, $F_1$, is 2.5 dBm larger than its counterpart. Consequently, the mixer utilizing the capacitive cross-coupling pair at the LO switching stage has a 2.5 dB higher conversion gain. For a fair comparison, in the simulations mentioned above, a capacitive cross-coupled pair and an emitter coupled pair use the same transistors, DC biases, as well as the same LO signal.

It should be pointed out that the improvement of the conversion gain costs either extra DC power or extra LO power. The amplitudes of the fundamental, as a function of LO's amplitudes, for both the emitter coupled pair (fine line, fig 7) and the capacitive cross-coupled pair (bold line, fig 7) are shown in fig 7, from which it can be found that $F_1$ of the capacitive cross-coupled transistor pair is always larger than that of its emitter-coupled counterpart.

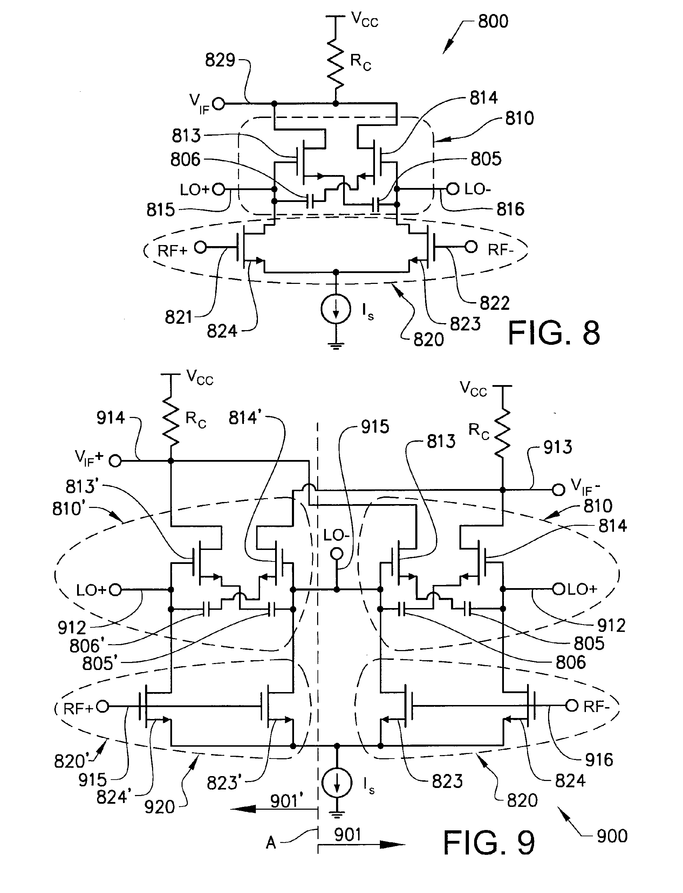

As pointed out previously in this text, the bipolar transistors of the embodiments shown in figs 2-4 can be exchanged for FET transistors. Fig 8 shows an embodiment 800 of the mixer of fig 2, in which FET transistors are used. Thus, in the mixer circuit of fig 8, the sources of the transistors in the trance-conductance stage 820 are coupled to each other and to ground via a DC current source $I_e$, and the gates of the transistors in the trance-conductance stage 820 form respective differential input ports 821 and 822 for a first input signal (RF+/-) at a first frequency, and the sources of each of the transistors 813, 814 in the switching stage 810 form respective differential input ports 815, 816 for a second input signal (LO+/-) at a second frequency.

In the mixer circuit 800, the transistors 813, 814, in the switching stage 810 are capacitively cross-coupled to each other by means of the gate of each transistor in the switching stage being coupled to the source of the other transistor in the switching stage via a capacitor 805, 806, and the drains of the transistors 813, 814 in the switching stage are also connected to each other and forming an output port ($V_{IF}$) for a mixer signal from the mixer circuit and as an input port for a DC supply voltage ($V_{CC}$) for the mixer circuit via a resistor $R_C$.

Fig 9 shows a Gilbert mixer 900 similar in structure to the one 300 in fig 3, but with FET transistors instead of bipolar junction transistors. Thus, the Gilbert mixer 900 comprises a first and a second mixer circuit 901, 901' as described in fig 8, in which first and second mixer circuits the connection between the drains of the transistors in the switching stage 910, 910', is opened.

In the Gilbert mixer 900, the first and second mixer circuits 901, 901', are connected by means of a connection between the sources of a first transistor 813, 814', in each switching stage 910, 910', of the mixer circuits and by means of the sources of the transistors 824', 823', 824, 823, in the trans-conductance stages 920, 920' of the mixer circuits 901, 901', which are connected to each other as well as being connected to ground via a DC current source $I_S$.

In the Gilbert mixer 900, the gates of the transistors 824', 823', 824, 823 in each trans-conductance stage 920, 920' of the first and second mixers 901, 901' are connected to each other, and the sources of a second transistor 813', 814, in each of the switching stages are connected to each other and form a first differential input port 911, 912, for a second input signal (LO) at a second frequency. The connection between the first and second mixer circuits form a second differential input port 915 for the second input signal, and the connected gates of the transistors 824', 823', 824, 823 in the trans-conductance stages 920, 920', of each of the mixer circuits form differential input ports 915, 916, for a first input signal (RF+/-) at a first frequency.

The drains of the first transistor 813, 814', in each transistor pair in the switching stages 910, 910', are connected to the drains of the second transistor 813', 814, in each pair in the switching stage, and thereby form respective differential output ports 913, 914, for a differential output signal ($V_{IF}$+/-) of the Gilbert mixer, as well as forming an input port for a DC voltage supply ($V_{CC}$) via a resistor ($R_C$).

In the drawings and specification, there have been disclosed exemplary embodiments of the invention. However, many variations and modifications can be made to these embodiments without substantially departing from the principles of the present invention. Accordingly, although specific terms are employed, they are used in a generic and descriptive sense only and not for purposes of limitation.

The invention is not limited to the examples of embodiments described above and shown in the drawings, but may be freely varied within the scope of the appended claims.


**Claims**

1. A mixer circuit (200, 800) with a switching stage (210, 810) comprising a first (214, 814) and a second (213, 813) transistor and with a trans-conductance stage (220, 820) comprising a first (223, 823) and a second (224, 824) transistor, in which mixer circuit the transistors are bipolar junction/FET transistors, and the emitters/sources of the transistors (223, 224; 823, 824) in the trance-conductance stage (220, 820) are coupled to each other as well as being coupled to ground via a DC current source ($I_e$), with the bases/gates of the transistors (223, 224; 823, 824) in the trance-conductance stage (220, 820) forming respective differential input ports (221, 222; 821, 822) for a first input signal (RF+/-) at a first frequency, and the collector/drain of the first transistor in the trans-conductance stage is connected to the emitter/source of the first transistor in the switching stage and the collector/drain of the second transistor in the trans-conductance stage is connected to the emitter/source of the second transistor in the switching stage with the emitter/source of each of the transistors (213, 214; 813, 814) in the switching stage forming respective differential input ports (215, 216; 815, 816) for a second input signal (LO+/-) at a second frequency, the mixer circuit being **characterized in that** the transistors (213, 214; 813, 814) in the switching stage (210, 810) are capacitively cross-coupled to each other by means of the base/gate of each transistor in the switching stage being coupled to the emitter/source of the other transistor in the switching stage via a capacitor (205, 206; 805, 806), with the collectors/drains of the transistors (213, 214; 813, 814) in the switching stage (210, 810) also being connected to each other and forming an output port ($V_{IF}$) for a mixer signal from the mixer circuit as well as forming an input port for a DC supply voltage ($V_{CC}$) for the mixer circuit via a resistor ($R_C$).

2. A Gilbert mixer (300, 900), comprising a first (301, 901) and a second (301', 901') mixer circuit as defined in claim 1, with the exception that in said first (301, 901) and second (301', 901') mixer circuits the collectors/drains of the transistors in the switching stage (310, 310'; 910, 910') are not connected, in which Gilbert mixer (300, 900) the first (301, 901) and second (301', 901') mixer circuits are connected by means of a connection between the emitters/sources of a first transistor (213, 214'; 813, 814') in each switching stage (310, 310'; 910, 910') of the mixer circuits and by means of the emitters/sources of the transistors (224', 223', 224, 223; 824', 823', 824, 823) in the trans-conductance stages (220, 220'; 920, 920') of the mixer circuits (301, 301'; 901, 901'), which are connected to each other as well as being connected to ground via a DC current source ($I_e$), the Gilbert mixer (300, 900) additionally being **characterized in that** the bases/gates of the transistors (223, 224, 223', 224'; 824', 823', 824, 823) in each of the trans-conductance stages (220, 220'; 920, 920') of said first (301, 901) and second (301', 901') mixers are connected to each other, in which Gilbert mixer (300, 900) the emitter/source of a second transistor (213', 214, 813', 814) in each of the switching stages are connected to each other and form a first differential input port (312, 912) for a second input signal (LO) at a second frequency, with the connection between the first (301, 901) and second (301', 901') mixer circuits forming a second differential input port (315, 915) for the second input signal (LO), and the connected bases/gates of the transistors (223, 224; 223', 224'; 824', 823, 824, 823) in the trans-conductance stages of each of the mixer circuits form differential input ports (316, 315; 915, 916) for a first input signal (RF+/-) at a first frequency, with the collector/drain of the first transistor (213, 214'; 813, 814') in each transistor pair in the switching stages being connected to the collector/drain of the second transistor (213', 214; 813', 814) in the other switching stage, thereby forming respective differential output ports ($V_{IF}$+/-) for a differential output signal of the Gilbert mixer, as well as forming an input port for a DC voltage supply ($V_{CC}$) via a resistor ($R_C$).

## Patentansprüche

1. Ein Mischerkreis (200, 800) mit einer Schaltstufe (210, 810), aufweisend einen ersten (214, 814) und einen zweiten (213, 813) Transistor, und mit einer Transkonduktanzstufe (220, 820), aufweisend einen ersten (223, 823) und einen zweiten Transistor (224, 824),
wobei in dem Mischerkreis die Transistoren Bipolartransistoren / Feldeffekttransistoren sind, und
wobei die Emitter / die Sources von den Transistoren (223, 224; 823, 824) in der Transkonduktanzstufe (220, 820) miteinander und mit Masse über eine Gleichsstromquelle ($I_e$) verbunden sind,
wobei die Basen / die Gates von den Transistoren (223, 224; 823, 824) in der Transkonduktanzstufe (220, 820) jeweils differentielle Eingangsanschlüsse (221, 222; 821, 822) für ein erstes Eingangssignal (RF +/-) bei einer ersten Frequenz bilden, und
wobei der Kollektor / das Drain von dem ersten Transistor in der Transkonduktanzstufe mit dem Emitter / der Source von dem ersten Transistor in der Schaltstufe verbunden ist, und
wobei der Kollektor / das Drain von dem zweiten Transistor in der Transkonduktanzstufe mit dem Emitter / der Source von dem zweiten Transistor in der Schaltstufe verbunden ist,
wobei der Emitter / die Source von jedem der Transistoren (213, 214; 813, 814) in der Schaltstufe jeweils differentielle Eingangsanschlüsse (215, 216; 815, 816) für ein zweites Eingangssignal (LO +/-) bei einer zweiten Frequenz bilden,
wobei der Mischerkreis **dadurch gekennzeichnet ist, dass** die Transistoren (213, 214; 813, 814) in der Schaltstufe (210, 810) miteinander kapazitiv quer-verbunden sind, indem das Basis / das Gate von jedem Transistor in der Schaltstufe mit dem Emitter / der Source von dem anderen Transistor in der Schaltstufe über einen Kondensator (205, 206; 805, 806) verbunden sind,
wobei die Kollektoren / die Drains von den Transistoren (213, 214; 813, 814) in der Schaltstufe (210,810) auch miteinander verbunden sind und einen Ausgangsanschluss ($V_{IF}$) für ein Mischsignal von dem Mischerkreis bilden und über einen Widerstand ($R_C$) einen Eingangsanschluss für eine Gleichstrom - Versorgungsspannung ($V_{CC}$) für den Mischerkreis bilden.

2. Ein Gilbert - Mischer (300, 900), aufweisend einen ersten (301, 901) und einen zweiten (301', 901') Mischerkreis wie in Anspruch 1 definiert, mit der Ausnahme, dass in den ersten (301, 901) und in dem zweiten (301', 901') Mischerkreisen die Kollektoren / die Drains von den Transistoren in der Schaltstufe (310, 310'; 910; 910') nicht verbunden sind,
wobei in dem Gilbert - Mischer (300, 900) die ersten (301, 901) und die zweiten (301', 901') Mischerkreise verbunden sind über eine Verbindung zwischen den Emittern / den Sources von einem ersten Transistor (213, 214'; 813, 814') in jeder Schaltstufe (310, 310'; 910, 910') von den Mischerkreisen und über die Emittern / die Sources von den Transistoren (224',223'; 224, 223; 824', 823', 824, 823) in den Transkonduktanzstufen (220, 220'; 920, 920') von den Mischerkreisen (301, 301'; 901, 901'), welche miteinander verbunden sind und über eine Gleichstromquelle ($I_E$) mit Masse verbunden sind,
wobei der Gilbert - Mischer (300, 900) weiterhin **dadurch gekennzeichnet ist, dass** die Basen / die Gates von den Transistoren (223, 224, 223', 224'; 824', 823', 824, 823) in jeder von den Transkonduktanzstufen (220, 220'; 920, 920') von den ersten (301, 901) und den zweiten (301', 901') Mischern miteinander verbunden sind,
wobei in dem Gilbert - Mischer (300, 900) die Emitter / die Source von einem zweiten Transistor (213', 214, 813', 814) in jeder von den Schaltstufen miteinander verbunden sind und einen ersten differentiellen Eingangsanschluss (312, 912) für ein zweites Eingangssignal (LO) bei einer zweiten Frequenz bilden,
wobei die Verbindung zwischen den ersten (301 ,901) und den zweiten (301', 901') Mischerkreisen einen zweiten differentiellen Eingangsanschluss (315, 915) für das zweite Eingangssignal (LO) bildet, und
wobei die verbundenen Basen / Gates von den Transistoren (223, 224; 223', 224'; 824', 823', 824, 823) in den Transkonduktanzstufen von jedem der Mischerkreise differentielle Eingangsanschlüsse (316, 315; 915, 916) für ein erstes Eingangssignal (RF +/-) bei einer ersten Frequenz bilden,
wobei der Kollektor / das Drain von dem ersten Transistor (213, 214'; 813, 814') in jedem Transistorpaar in den Schaltstufen mit dem Kollektor / dem Drain von einem zweiten Transistor (213', 214; 813', 814) in der anderen Schaltstufe verbunden ist, und dadurch jeweilige differentiellen Ausgangsschlüsse ($V_{IF}$ +/-) für ein differentielles Ausgangssignal von dem Gilbert - Mischer gebildet werden, und über einen Widerstand ($R_C$) ein Eingangsanschluss für eine Gleichstrom - Spannungsversorgung ($V_{CC}$) gebildet wird.

## Revendications

1. Circuit mélangeur (200, 800) avec un étage de commutation (210, 810) comprenant un premier (214, 814) et un second (213, 813) transistors et avec un étage de transconductance (220, 820) comprenant un premier (223, 823) et un second (224, 824) transistors, dans le circuit mélangeur les transistors sont des transistors à jonction bipolaire/à effet de champs, et les émetteurs/sources des transistors (223, 224 ; 823, 824) de l'étage de transconductance (220, 820) sont couplés les uns aux autres tout en étant couplés à la masse par l'intermédiaire d'une source de courant continu ($I_e$), avec les bases/portes des transistors (223, 224 ; 823, 824) de l'étage de transconductance (220, 820) formant des ports d'entrée différentiels respectifs (221, 222 ; 821, 822) pour un premier signal d'entrée (RF+/-) à une première fréquence, et le collecteur/drain du premier transistor de l'étage de transconductance est relié à l'émetteur/source du premier transistor de l'étage de commutation et le collecteur/drain du second transistor de l'étage de transconductance est relié à l'émetteur/source du second transistor de l'étage de commutation avec l'émetteur/source de chacun des transistors (213, 214 ; 813, 814) de l'étage de commutation formant des ports d'entrée différentiels respectifs (215, 216 ; 815, 816) pour un second signal d'entrée (LO+/-) à une seconde fréquence, le circuit mélangeur étant **caractérisé par le fait que** les transistors (213, 214 ; 813, 814) de l'étage de commutation (210, 810) sont en couplage croisé capacitif l'un avec l'autre au moyen de la base/porte de chaque transistor de l'étage de commutation étant couplés à l'émetteur/source de l'autre transistor de l'étage de commutation par l'intermédiaire d'un condensateur (205, 206 ; 805, 806), avec les collecteurs/drains des transistors (213, 214 ; 813, 814) dans l'étage de commutation (210, 810) étant également reliés les uns aux autres et formant un port de sortie ($V_{IF}$) pour un signal de mélangeur du circuit mélangeur ainsi que formant un port d'entrée pour une tension d'alimentation continue ($V_{CC}$) pour le circuit mélangeur par l'intermédiaire d'une résistance ($R_C$).

2. Mélangeur de Gilbert (300, 900), comprenant un premier (301, 901) et un second (301', 901') circuit mélangeur selon la revendication 1, avec l'exception que dans ledit premier (301, 901) et second (301', 901') circuits mélangeurs les collecteurs/drains des transistors de l'étage de commutation (310, 310' ; 910, 910') ne sont pas reliés, dans le mélangeur de Gilbert (300, 900) le premier (301, 901) et second (301', 901') circuits mélangeur sont reliés au moyen d'une connexion entre les émetteurs/sources d'un premier transistor (213, 214' ; 813, 814') dans chaque étage de commutation (310, 310' ; 910, 910') du circuit mélangeur et au moyen des émetteurs/sources des transistors (224', 223', 224, 223 ; 824', 823', 824, 823) dans les étages de transconductance (220, 220' ; 920, 920') des circuits mélangeur (301, 301' ; 901, 901'), qui sont reliés les uns aux autres tout en étant reliés à la masse par l'intermédiaire d'une source de courant continu ($I_e$), le mélangeur de Gilbert (300, 900) étant en outre **caractérisé par le fait que** les bases/portes des transistors (223 , 224, 223', 224' ; 824', 823', 824, 823) dans chacun des étages de transconductance (220, 220' ; 920, 920') desdits premier (301, 901) et second (301', 901') mélangeurs sont reliés les uns aux autres, dans le mélangeur de Gilbert (300, 900) l'émetteur/source d'un second transistor (213', 214, 813', 814) dans chacun des étages de commutation sont reliés les uns aux autres et forment un premier port d'entrée différentiel (312, 912) pour un second signal d'entrée (LO) à une seconde fréquence, avec la connexion entre le premier (301, 901) et second (301', 901') circuits mélangeurs formant un second port d'entrée différentiel (315, 915) pour le second signal d'entrée (LO), et les bases/portes reliées des transistors (223, 224; 223', 224' ; 824', 823', 824, 823) des étages de transconductance de chacun des circuits mélangeurs forment des ports d'entrée différentiels (316, 315 ; 915, 916) pour un premier signal d'entrée (RF+/-) à une première fréquence, avec le collecteur/drain du premier transistor (213, 214' ; 813, 814') de chaque paire de transistors dans les étages de commutation étant reliés au collecteur/drain du second transistor (213', 214 ; 813', 814) dans l'autre étage de commutation, en formant ainsi des ports de sortie différentiels respectifs ($V_{IF}$+/-) pour un signal de sortie différentiel du mélangeur de Gilbert, ainsi que la formation d'un port d'entrée pour une alimentation en tension continue ($V_{CC}$) par l'intermédiaire d'une résistance (Rc).

FIG. 1 Prior Art

FIG. 2

FIG. 3

FIG. 4

FIG. 5

FIG. 6

FIG. 7

FIG. 8

FIG. 9

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 2263308 A

**Non-patent literature cited in the description**

• Using capacitive cross-coupling technique in RF low noise amplifiers and down-conversion mixer design. **W. ZHUO et al.** proceedings of the 26rd European Solide-State circuits conference, ESSCIRC'00, Stockholm, Sweden. IEEE, 19 September 2000, 77-80